# EUROPEAN PATENT APPLICATION

(11) **EP 1 638 041 A1**
(43) Date of publication of application: **22.03.2006**
(21) Application number: 04022426.3
(22) Date of filing: 21.09.2004
(51) Int. Cl.: G06K 19/077

(54) **Method of embedding an RFID label into an electronic device, such as a printed circuit board**

(71) Applicant: TOPSEED TECHNOLOGY CORP., Chung Ho City, Taipei Hsien, Taiwan 235 (TW)
(72) Inventor: Chen, Shoei-Lai, Taipei 237 (TW)
(74) Representative: TER MEER - STEINMEISTER & PARTNER GbR

(57) **Abstract**

A method for embedding an electronic label within the circuit board of an electronic device, which plants and incorporates the electronic label into the electronic device, protects the electronic label from separation or damage caused by external force, and thereby facilitates the sale management or manufacture management of various electronic devices. The method includes obtaining the electronic device, selecting a recognition area on the electronic device, orienting a Radio Frequency Identification (RFID) tag at the recognition area, translating relevant merchandise information of the electronic device into digital codes, and burning the digital codes into the RFID tag for storage. Compared to the conventional arts which glue, one by one, a RFID tag onto an electronic device, the manufacturing procedure is greatly simplified. The assembling cost and time are thereby reduced in a large scale.

## Description

### BACKGROUND OF THE INVENTION

The present invention relates in general to a method for building an electronic label within an electronic device, and more particularly, to a method which plants or incorporates an electronic label into an electronic device, and thereby protects the electronic label from separation or damage caused by external force.

To manufacture or sell a product, a product label is utilized to record the relevant merchandise information about the product. The relevant merchandise data includes the manufacturer's name, product name, manufacture date, product specifications, corresponding device's specifications, batch number, and other recognition data created by manufacturers for management. Especially for some electronic devices such as circuit boards or devices including circuit boards, merchandise recognition labels are more important and necessarily in sale management, storage management, and service management.

Conventional merchandise recognition label system prints a chattel label on self-adhesive paper for further gluing, one by one, onto the surface of the product. Limited by the small area of a label, the merchandise information of an average chattel is unable to be recorded or shown thoroughly. Therefore, it may need more labels to provide different information. That is, the product has to provide more space for the labels. However, for electronic devices, especially the circuit boards have built lots of electric circuits and electronic components thereon. Usually, it is hard to provide enough space for the conventional labels. Furthermore, paper labels have many drawbacks. Paper labels are easy to be removed for counterfeiting. The merchandise information printed on the labels is also likely to be erased or to become vague due to a damp climate, raining, or rubbing. This loss of the merchandise information makes it troublesome for businesses to proceed with the manufacturing or sale of the product.

Further, accompanying the constant improvement and development of electronic technology, a Radio Frequency Identification (RFID) System has been utilized to facilitate the management of various chattels. The RFID system includes a transceiver and a RFID tag. The RFID tag includes an IC chip and a resonance circuit which is constituted by an antenna and one or more capacitors. The transceiver emits radio signals to activate the RFID tag and acquires the merchandise information from the RFID tag. This RFID system is able to quickly provide a large amount of product information for recognition, management, and tracking. However, the current utilization of the RFID system is to stick the RFID tag onto a surface of the product. That is unable to protect the RFID tag from fracture, separation, or other damage. It is also unable to prevent the electronic device from being counterfeited.

### BRIEF SUMMARY OF THE INVENTION

The present invention provides a method of building an electronic label for an electronic device. This method plants and incorporates the electronic label into the electronic device, and thereby protects the electronic label from separation or damage caused by external force.

The method for building an electronic label within an electronic device provided by the present invention includes obtaining the electronic device, selecting a recognition area on the electronic device, orienting a Radio Frequency Identification (RFID) tag at the recognition area, translating relevant merchandise information of the electronic device into digital codes, and burning the digital codes into the RFID tag for storage. Compared to the conventional arts which glue, one by one, a RFID tag onto an electronic device, the manufacturing procedure of the present invention is greatly simplified. The assembling cost and time are thereby reduced in a large scale. Further, because the electronic label is enclosed inside the electronic device, it is protected from damage or separation due to external force.

These and other objectives of the present invention will become obvious to those of ordinary skill in the art after reading the following detailed description of preferred embodiments.

It is to be understood that both the foregoing general description and the following detailed description are exemplary, and are intended to provide further explanation of the invention as claimed.

### BRIEF DESCRIPTION OF THE DRAWINGS

These as well as other features of the present invention will become more apparent upon reference to the drawings therein:
Figure 1 is a flow chart of a method of building an electronic label for an electronic device according the present invention.
Figure 2 is a schematic perspective view of an electronic device which utilizes the present invention to enclose an electronic label.

### DETAILED DESCRIPTION OF THE INVENTION

Reference will now be made in detail to the preferred embodiments of the present invention, examples of which are illustrated in the accompanying drawings. Wherever possible, the same reference numbers are used in the drawings and the description to refer to the same or like parts.

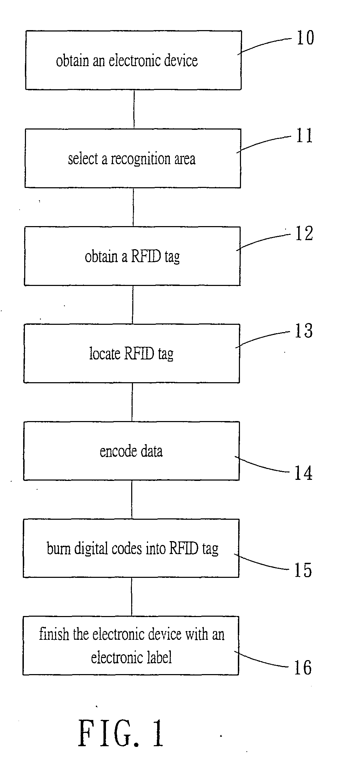

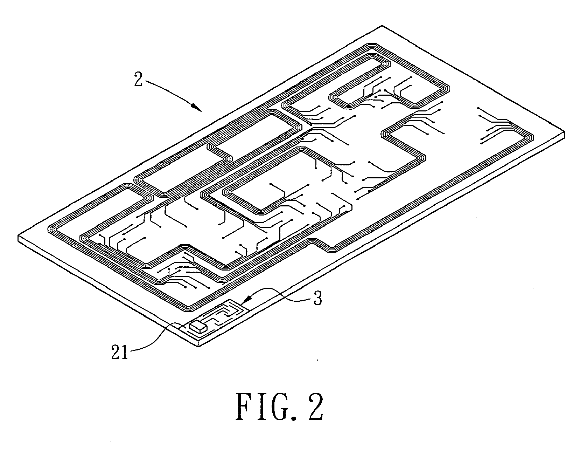

Referring to figure 1 and figure 2, a flow chart of a method for building an electronic label within an electronic device of the present invention and a schematic perspective view of an electronic device utilizing the present invention are shown respectively. The present invention is utilized to produce an electronic device 2 which encloses a RFID tag 3 as an electronic label for the recognition, management, and tracking of the electronic device 2. The method of the present invention includes at least the following steps:
Step 10: obtaining an electronic device 2, such as a circuit board. In another embodiment, it may be utilized in other electronic devices.
Step 11: selecting an area on the electronic device 20 as a recognition area 21. The recognition area 21 can be located at any suitable position on one surface of the electronic device 2, such as shown in figure 2.
Step 12: obtaining a RFID tag 3 which includes a resonance circuit constituted by an antenna and one or more capacitors.
Step 13: planting or incorporating the RFID tag 3 onto the recognition area 21.
Step 14: translating the relevant merchandise information of the electronic device 2 into digital codes. The relevant merchandise information of the electronic device 1 includes, for example, the manufacturer's name, the product's name, the manufacturing date, product specifications, corresponding device's specifications, the batch number, and other recognition data created by manufacturers for management.
Step 15: burning the digital codes into the RFID tag 3 for storage.
Step 16: finishing an electronic device 2 which encloses the RFID tag 3.

By sequentially carrying out the aforementioned procedure of the method for building an electronic label within an electronic device of the present invention, the RFID tag 3 is capable of being planted and incorporated into the electronic device 2 at one surface of the electronic device 2, as illustrated in figure 2. Compared to the conventional arts which glue, one by one, a RFID tag onto an electronic device, the manufacturing procedure of the present invention is greatly simplified. The assembling cost and time are thereby reduced in a large scale. Furthermore, because the electronic label is enclosed inside the electronic device 2, it is protected from damage or separation due to external force.

In addition, the antenna of the RFID tag 3 electrically connects to one pin of the electronic device 2. The electronic device 2 is thereby able to transmit its relevant merchandise information through radio signals.

While an illustrative and presently preferred embodiment of the invention has been described in detail herein, it is to be understood that the inventive concepts may be otherwise variously embodied and employed and that the appended claims are intended to be construed to include such variations except insofar as limited by the prior art.

## Claims

1. A method of building an electronic label for an electronic, comprising the steps of:
obtaining the electronic device;
selecting a recognition area on the electronic device;
orienting a Radio Frequency Identification (RFID) tag at the recognition area; translating relevant merchandise information of the electronic device into digital codes; and
burning the digital codes into the RFID tag for storage.

2. The method of Claim 1, wherein the electronic device is a circuit board.

3. The method of Claim 1, wherein the RFID tag includes a resonance circuit electrically connected to the electronic device, and the resonance circuit includes an antenna and one or more capacitors.

4. The method of Claim 1, wherein the translation step includes encoding manufacturer's names, product names, manufacture date, product specifications, batch number, or recognition data created by manufacturers for management into the digital codes.

5. A method of building an electronic label for an electronic device, comprising the steps of:
obtaining the electronic device;
orienting a Radio Frequency Identification (RFID) tag on the electronic device;
translating relevant merchandise information of the electronic device into digital codes; and
burning the digital codes into the RFID tag for storage.

6. The method of Claim 5, wherein the electronic device is a circuit board.

7. The method of Claim 5, wherein the RFID tag is planted onto one surface of the electronic device.

8. The method of Claim 5, wherein the RFID tag includes a resonance circuit electrically connected to the electronic device, and the resonance circuit includes an antenna and one or more capacitors.

9. The method of Claim 5, wherein the translation step includes encoding manufacturer's names, product names, manufacture date, product specifications, batch number, or recognition data created by manufacturers for management into the digital codes.
